# EUROPEAN PATENT SPECIFICATION

(11) **EP 1 393 109 B1**
(45) Date of publication and mention of the grant of the patent: **28.09.2005**
(21) Application number: 02743019.8
(22) Date of filing: 15.05.2002
(51) Int. Cl.: G02B 6/42, G02B 6/36

(54) **DEVICE FOR HOLDING AN OPTICAL FIBRE**
ANORDNUNG ZUM HALTERN EINER OPTISCHE FASER
DISPOSITIF DE SUPPORT D'UNE FIBRE OPTIQUE

(30) Priority: 16.05.2001 US 291225 P
(43) Date of publication of application: 03.03.2004
(73) Proprietor: Motorola Broadband Nürnberg GmbH, 90441 Nürnberg (DE)
(72) Inventor: GRAUVOGEL, Ulrich, 90451 Nürnberg (DE); LEICHT, Günter, 96047 Bamberg (DE)
(74) Representative: Schröer, Gernot H.
(86) International application number: PCT/EP2002/005353
(87) International publication number: WO 2002/093223

(56) References cited:
- EP-A- 0 484 167
- WO-A-02/12940
- GB-A- 2 277 206
- US-A- 4 707 066
- PATENT ABSTRACTS OF JAPAN vol. 006, no. 189 (E-133), 28 September 1982 (1982-09-28) & JP 57 100781 A (FUJITSU LTD), 23 June 1982 (1982-06-23)

## Description

The present invention relates to a device for holding a light guide, in particular an optical fiber, preferably a glass fiber.

In cable television system (cable TV systems) television signals are transmitted from a cable television supplier or provider to a community of many different TV users via or through electrical coaxial cables or optical cables comprising glass fibers. In order to obtain a large bandwidth an optical transmission via optical cables or fibers is getting more and more common. But within the CATV communities themselves the already installed electrical coaxial cables in the buildings are still used. Therefore, the amplitude modulated (AM) optical television signals transmitted through the optical cables have to be converted into corresponding radio frequency (high frequency) electrical television signals by photoelectric (or: optoelectric, optoelectronic) transducers (or: converters) such as PIN photodetector diodes or other photodetectors.

An electrical output of the photoelectric transducer is mounted on and electrically connected to an electrical CATV amplifier for amplifying the converted electrical signals at the output of the transducer. The transducer is arranged within a protective housing.

Furthermore, the photoelectric transducer is fixedly connected to the end of an optical fiber, typically a glass fiber, for transmitting the optical signals to the optical input of the transducer.

An optoelectronic transducer for use in a CATV optical receiver module comprising an electrical amplifier and the mounted photoelectric transducer is disclosed in US 5,627,531 A. This known optoelectronic transducer contains a photonic device such as a photodiode or a light emitting diode or laser fixed to a photonic device carrier of ceramic material and further contains a fiber carrier having a groove which an end portion of an optical single or multi mode fiber is mounted and fixed in by means of solder or adhesive. The fiber carrier is provided with a reflective surface and connected to the photonic device carrier in such a manner that the reflective surface is aligned with the optical fiber and the photonic device. This known optoelectronic transducer can be used either for converting optical into electrical signals in the conventional cable TV application or for converting electrical into optical signals in modern interactive or bidirectional cable TV systems allowing for a signal transmission in the opposite direction from the TV user to the TV provider, the type of the encapsulated photonic device depending on the required signal direction.

A number of methods and devices are known in the art that are capable of mounting a photoelectric transducer with the glass fiber to an electronic substrate of a CATV amplifier.

It is known to mount the photoelectric transducer onto the substrate by soldering it to a mechanical metal clamp as a transducer carrier which in turn is soldered to the substrate.

Another particular method of mounting a photoelectric transducer to a substrate involves using an adhesive, such as one of UV-curable or thermosetting resins, for glueing the transducer and preferably also the optical fiber to a plastic carrier and the carrier to the substrate.

The optical fiber connected to the transducer according to the prior art is passed through an opening in the protective housing for the transducer and protected by a stiff rubber boot which is held fixedly and non-positively within the opening of the protective housing. Such a non-flexible holding device or bearing for the optical fiber has the advantage that pull stress is absorbed by the bearing and that a bending of the fiber outside the protective housing does not lead to a bending of the fiber inside the housing and, thus, damage to the fiber or the transducer or the connection between fiber and transducer inside the housing is avoided. However, when the fiber is bent outside of the housing high bending stress is generated in the fiber at the location of the bearing which can damage or even destroy the fiber in the vicinity outside of the bearing. Now, at the assembly of optical receiver such bending of the optical fiber beyond the maximum tolerance of the fiber can not always be avoided and leads to losses in the production process. Similar problems can arise with the handling of light guides or optical fibers in other applications.

US 4,707,066 A discloses a device for holding a glass fiber having a membrane which is elastic and holds a stiff tube firmly surrounding a glass fiber in an inner passage. The membrane is engaged within an opening. During an adjustment process the stiff tube is moved within the membrane for adjusting the tip of the glass fiber. Afterwards, the tube is fixed by fixing means and can not be moved anymore.

GB 2 277 206 A discloses a cable sealing and locking device, in particular for optical fiber cables. The cable is surrounded by a tubular body comprising an outer sleeve of relatively incompressible elastomeric material and an inner sleeve of relatively soft and compressible elastomeric material. The relatively long tubular body prevents the cable from being bent more than the maximum bend radius. The cable has to be fed through the tubular body along its longitudinal axis.

It is, therefore, an object of the invention to provide a device for holding a light guide, in particular an optical fiber, preferably a glass fiber, whereby the risk of damage to the fiber through bending is reduced.

This object and other objects are achieved, according to the invention, by the features of claim 1.

The device according to claim 1 is adapted and meant for holding a light guide, in particular an optical fiber, preferably a glass fiber, and comprises
a) at least one bearing having
   a1) a reversibly deformable inner bearing section being provided with an opening or passage for the light guide and
   a2) an outer bearing section which is less deformable (or: harder) than the inner bearing section,
b) wherein the inner bearing section and the outer bearing section are formed and arranged in such a manner that the light guide can be moved within the bearing under deformation of the inner bearing section, such movement being limited by the outer bearing section, or the outer bearing section, or, in other words, the outer bearing serving as a stop for the movement of the light guide.

Furthermore, according to claim 1 the bearing is composed of two separate bearing parts. This allows for an easy assembly of the light guide which can be placed in one of the bearing parts and the other bearing part can be mounted thereon.

A first part of the outer bearing section and, in particular the whole inner bearing section is included in one of the bearing parts and a second part of the outer bearing section is included in the other bearing part. Thus, the light guide is completely received within one bearing part and the other bearing part serves to complete the outer bearing section. This faciliates the assembly since the light guide can be pre-mounted in the first bearing part.

The terms "optical" or "light" include not only the visible spectrum but also the infrared spectrum. The term "light guide" includes in particular single optical fibers and bundles of optical fibers with or without coatings, jackets and/or claddings or any type of optical cable.

The invention is based on a first consideration to provide a flexible or deformable holding part for the light guide so that the light guide can be transversally displaced within this holding part. The deformability is reversible so that any deformation of this holding part will or can be reversed when the displacement of the light guide is reversed. The reversibly deformable holding part is formed by the inner bearing section of the bearing for the light guide. The light guide is led through and held within the passage or opening of the inner bearing section.

The invention is further based on a second consideration to allow only for a limited movement of the light guide by providing a stop part for stopping the movement of the light guide, in particular a transversal movement. This stop part is formed by the outer bearing section of the bearing which is less deformable than the inner bearing section so that if the light guide deforms the inner bearing section and reaches the outer bearing section it will be stopped there.

Thus, the light guide is not held tightly within the device but suspended with a pre-determent tolerance within the device. In other words, compared to the prior art, further mechanical degrees of freedom for the light guide are introduced by the device according to the invention. If the light guide is bent at one side of the bearing such a bending will result in a movement of the light guide at least within the bearing thus decreasing the bending stress in the light guide near the bearing.

Given a light guide with a given minimal admissible bend radius or a maximal bending curvature the following advantages over the prior art can be mentioned:

Given the same displacement of the light guide, bending stress on or within the light guide at the same distance from the bearing is significantly reduced compared to the fixed bearing according to the prior art.

Or, given the same bending stress in the light guide at the same distance from the bearing, the (possible) displacement of the light guide held in the bearing according to the invention is larger than in the prior art.

The bending curvature at one position or point of the light guide is, as usual, defined by the second derivative of that position of the light guide along the longitudinal direction of the light guide, the radius of curvature or bend radius usually defined as the reciprocal value of the curvature.

Preferred embodiments and applications of the device according to the invention are claimed in the dependent claims referring back to claim 1.

A displacement of the light guide at one side of the bearing, in particular a transversal displacement such as a bending, leads, in a preferred and advantageous embodiment, to a deformation of the inner bearing section and, thus, in a bending or displacement of the light guide on the other side of the bearing. In particular, the displacement of the light guide on the other side is opposite to the displacement on the first side whereby the bending curvature of the light guide is decreased compared to the prior art.

In particular, the bearing can be described as a pivoting area for the light guide. The light guide, therefore, pivots within the bearing with its optical axis, quite like a lever, when the light guide is bent or displaced at one side of the bearing. This function could also be called a "center of rotation" since the light guide somewhat rotates with its longitudinal direction or optical axis around or within the bearing. Usually the pivoting or rotational movement of the light guide within the bearing takes place in a rotational plane containing the direction of the displacement outside of the bearing.

In a normal position, which can also be called off-set position or zero position, the light guide is arranged within the opening of the inner bearing section while the inner bearing section is not deformed or only deformed to a minimal extent. The re-adjusting forces exerted by the inner bearing section onto the light guide are, thus, minimal or practically zero in the normal position under balanced conditions.

Preferably, the light guide is held non-positively or under pre-stress in the inner bearing section so as to define a predetermined position and/or, when the inner bearing section encloses the light guide along its circumference, to form a sealing for the light guide.

Furthermore, the light guide is preferably spaced apart from the outer bearing section in the normal position, in particular held in a central region of the bearing section.

In an advantageous embodiment, in the normal position, the light guide extends longitudinally along a straight longitudinal axis through the bearing, the light guide thus being aligned through the inner bearing section along a straight line. Preferably the inner bearing section extends at least approximately transversally or orthogonal to this longitudinal axis.

The contacting area with which the inner bearing section is in contact with the light guide has, in a preferred embodiment, a longitudinal extension which is smaller than the diameter of the opening or passage in the inner bearing section and/or then smaller than a diameter of the light guide, in particular by a factor of at least 1.5, preferably at least 2, in each case.

The term "diameter" in this application is meant to be the largest extension of the cross section and not necessary restricted to circular cross sections having just a single diameter.

In particular the inner bearing section can be shaped like a membrane or be provided with membrane characteristics.

The length or longitudinal extension of the inner bearing section outwardly from the contacting area or opening or passage for the light guide can vary, in particular increase.

In another preferred embodiment the width or outer diameter of the inner bearing section in at least one direction orthogonal to the longitudinal extension of the light guide within the inner bearing section is larger than the diameter or a maximum diameter of the opening or the light guide by a factor of at least 1.5, in particular at least 2.

The outer bearing section is, in an advantageous embodiment, provided with at least one side section for holding the inner bearing section and at least one front section being longitudinally displaced with respect to the inner bearing section or the side section for limiting the movement of the light guide. Thus, a maximum bending of the light guide will first be stopped by the front sections and will reduce the squeezing or pressure onto the inner bearing section.

The outer bearing section can be provided with a lower region having a curved stop surface for the light guide.

The opening or passage for the light guide can be accessible through a guiding passage for the light guide which is preferably smaller in its width or diameter than the opening or passage itself, thus, after inserting the light guide through the guiding passage, keeping the inserted light guide within the opening or passage.

The guiding passage can be closed by a protruding part of the other bearing part which also serves as a spacer or stop lug to prevent the light guide from contacting the outer bearing section.

Each of the bearing parts is preferably held in a corresponding hearing holding part.

The reversible deformability of the inner bearing section can be achieved by providing for elastic deformability or, alternatively, for a memory deformability. In case of memory deformability the material, especially by a specific activation, reverts to its original shape stored in the material's "memory". As such materials so called memory alloys could be used.

The preferred embodiment is, however, characterized in choosing an elastic, soft material and/or by providing areas with less material for allowing for bending of a spring type element. As an elastic material preferably an elastomer is chosen, in particular a thermoplastic elastomer. Preferably the bearing and its parts or sections are formed by injection moulding, in particular by two-shot-moulding for accomplishing parts or compounds of two different materials.

The Shore A value of the material for the bearing, at least for its the inner bearing section, is typically between 20 and 90. Such soft materials reduce the force applied to light guide considerably. The elasticity or softness of the inner bearing part is of course much higher than the elasticity or softness of the light guide, so that when the light guide is displaced it is basically only the inner bearing part that is deformed and not the light guide.

The light guide is often fixed at least on one side of the bearing at a fixing point or in an area which is distant from the bearing. Thus, a bending of the light guide on the opposite side of the bearing will result in a bending of the light guide between this fixing point and the bearing, whereas in the normal position usually the light guide is aligned along a straight line between the fixing point and the bearing.

By adjusting the distance between the fixing means and the bearing, the maximal displacement of the light guide at the other side of the bearing can be adjusted.

Also, in particular in connection with the fixing of the light guide, the light guide can be optically connected with the photoelectric transducer at one end, where in the photoelectric transducer is fixed and/or the light guide is fixed at a separate point, in particular by glueing.

When referring to the term "photoelectric" this includes the transformation of light or optical signals into electrical current or electrical signals as well as of electrical current or signals into light or optical signals. When the light guide is equipped and optically connected with a photoelectric transducer, a housing or cover for the transducer may be provided and is then equipped with a passage or opening carrying the bearing. The passage in the housing or cover for guiding the light guide and protecting it from mechanical stress and bending comprises, in this embodiment, preferably two corresponding cut-out sections in two separate housing parts forming, when mounted, an opening for the light guide. In this opening or in each of the cut-out sections preferably an elastic bearing part like a highly elastic, soft inlay body is arranged, the or both bearing parts forming a substantially loop- or ring-shaped bearing for the light guide within the opening. This embodiment allows for maximum bend of the glass fiber without inducing damage to glass fiber during the assembly of the transducer.

When the light guide is fixed as already mentioned, pull stress applied to the light guide, in particular from or to the transducer, is reduced.

The device for holding a light guide can also comprise several bearings arranged at a distance to each other, whereas each distance is preferably at least five times the diameter of the light guide or the opening or passage for the light guide. By selecting the distances between the bearings and the softness or deformability and dimensions and/or the mechanical resistance or the bearing forces of the bearings a defined profile or distribution of the curvature along the light guide can be obtained. Such a cascade of several different bearings could be used for obtaining smoother profiles with smaller curvatures in particular at the end or a fixing area of the light guide.

One application of the device according to the invention is for or in an optoelectric "hybrid" device such as an optoelectric receiver or transmitter or combined optoelectric receiver and transmitter conected to an electrical amplifier, in particular a CATV or cable television amplifier.

However, other applications of the holding device are possible such as, for instance, the holding of optical cables for telecommunication or other purposes in the ground.

The various features and advantages of the subject invention will be better understood by reference to the detailed description which follows taken in conjunction with the accompanying drawings, of which:
FIG 1 illustrates a mounting scheme for mounting a photoelectric transducer at a CATV amplifier in an exploded perspective (or: isometric) rear view,
FIG 2 shows a sequence of mounting steps for mounting the photoelectric transducer according to FIG 1 into its transducer carrier in a side view,
FIG 3 illustrates the transducer carrier with the mounted transducer after carrying out the mounting steps of FIG 2 in a perspective rear view,
FIG 4 illustrates the complete mounting scheme of FIG 1 after performance of the mounting steps of FIG 2 in an exploded rear view,
FIG 5 shows the transducer unit according to FIG 3 mounted onto the carrier in a perspective front view without the sidewall of the carrier holder,
FIG 6 illustrates a mounting scheme or assembly starting from FIG 4 after mounting of the transducer unit according to FIG 2 to 4 into the carrier holder and the carrier holder onto the CATV amplifier without the top cover in a perspective rear view,
FIG 7 shows the complete assembly resulting from that of FIG 5 and 6 by mounting the top cover and
FIG 8 shows a side view of the top cover and the carrier holder with the elastic bearing for the glass fiber in greater detail
FIG 9 is a magnified perspective view of the two bearing parts according to FIG 1 for the light guide,
FIG 10 shows the lower bearing part in a front view,
FIG 11 shows the lower bearing part according to FIG 10 in a view from above,
FIG 12 shows the upper bearing part in a front view,
FIG 13 shows the upper bearing part in a side view,
FIG 14 shows a bended light guide held in an elastic bearing,
FIG 15 shows a bended light guide held in a bearing according to the prior art,
FIG 16 illustrates a bended light guide held in a device according to the invention.

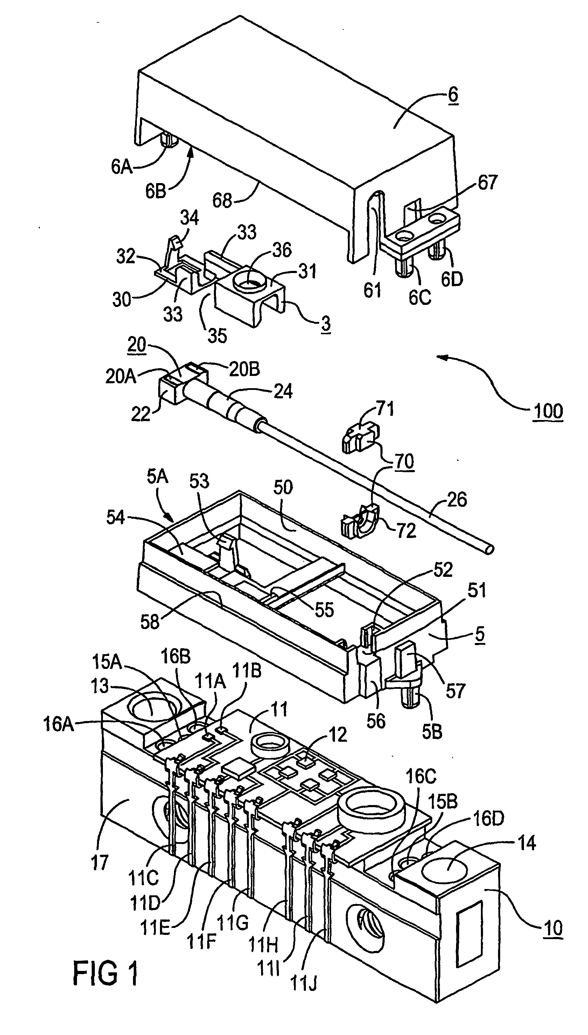

Like parts are designated by like reference symbols in FIG 1 through 16. It is worthy to note that any reference herein to "one embodiment" or "an embodiment" means that a particular feature, structure or characteristic described in connection with the embodiment is included in at least one embodiment of the invention. The appearances of the phrase "in one embodiment" in various places in the specification are not necessarily all referring to the same embodiment.

A conventional photoelectric transducer (or: photo detector) is designated by the reference numeral 20 and includes a body or housing containing a photodiode (or: photo detector diode) 22, in particular a PIN photo diode, a ferrule (or: holding sleeve) 24 and an end of a glass fiber (or any other light guide) 26 for transmitting optical or light signals to the photo diode 22 which converts these signals into electrical signals. The body with the enclosed photodiode 22 can be made of ceramic and preferably extends orthogonal to the ferrule 24 and glass fiber 26 so that a T- or hammer shaped structure of the photoelectric transducer 20 is obtained. On the top of the ceramic body with the photodiode 22 two electrical contacts 20A and 20B are arranged at a distance to each other which the photo voltage or current of the photodiode 22 can be detected at.

As a specific signal processing device a conventional cable television amplifier or CATV amplifier is shown and designated by the reference numeral 10 and comprises a, usually flat and often rectangular, substrate 11 and a substrate carrier body 17 carrying the substrate 11 and having dimensions according to the SOT115 international standard.

Electronic or electric signal processing and/or amplifying circuits 12 are arranged on the substrate 11, which can be formed as or by a printed circuit board or other printed substrate in thick or thin film technology. The amplifying circuits usually comprise differential cascade stage amplifier(s) equipped with Si or GaAs semiconducting devices, and/or integrated circuits. Also, electrical conductors are provided on the substrate 11 connecting the electronic circuits 12 with two electrical contacts 11A and 11B on the substrate 12 for connection to the corresponding contacts 20A and 20B of the photoelectric transducer 20 and several other electrical contacts 11C through 11K leading down at one side of the substrate carrier body 17 for signal input, signal output, battery (power supply) and ground connection.

The substrate carrier body 17 usually consists of metal or another material with good thermal conductivity in order to conduct heat generated by the operating electronic components or circuits 12 away from the substrate 11 and thus serves not only as a support but also as a heat sink or cooling body for the substrate 11. The - SOT115 shaped - substrate carrier body 17 has a symmetrical shape with two higher end or outer portions each having a screw hole 13 and 14 for screw connection to an amplifier housing (not shown) and a central portion which the substrate 11 is mounted onto. Between the end portions and the central portion two intermediate areas are formed adjacent to the central portion each containing an inner connection hole 15A and 15B and two outer connection holes 16A and 16B and 16C and 16D respectively. The distance of the two screw holes 13 and 14 is determined by the SOT115 standard.

In FIG 1 all parts of a preferred embodiment of a device for arranging the photoelectric transducer 20 at the signal processing device, i.e. the substrate 11 or the circuits 12 of the amplifier 10, are shown in a yet unassembled state. The device comprises a transducer carrier 3 for carrying and holding the photoelectric transducer 20, a carrier holder 5 (or: frame cover, lower housing part) for carrying and securing the transducer carrier 3, a top cover (or: top housing part) 6 and an elastic bearing 70 for the glass fiber 26 consisting of an upper bearing part 71 and a lower bearing part 72.

The transducer carrier 3 has a front area 30 for receiving the ceramic body with the photodiode 22 and a rear area 31 for enclosing and protecting the glass fiber 26. The front area 30 of the transducer carrier 3 has a bottom section 32 which the ceramic body with the photodiode 22 is laid upon, two side sections (or: side walls) 33 as holding and/or adjusting aids which the ferrule 24 is led through and laterally limited by, a hook-shaped snapping element 34 at the front for snapping in and holding firmly the ceramic body with the photodiode 22 and an opening 35 for inserting the transducer 20 into the transducer carrier 3. The rear area 31 of the transducer carrier 3 has a passage for the glass fiber 26 having a wall which is closed but at the bottom and provided with two openings for the glass fiber 26 and, furthermore, with a glue hole 36 at the top for optional glueing and, thus, permanently fixing the introduced glass fiber 26 into the transducer carrier 3 and preferably also to the carrier holder 5 when mounted.

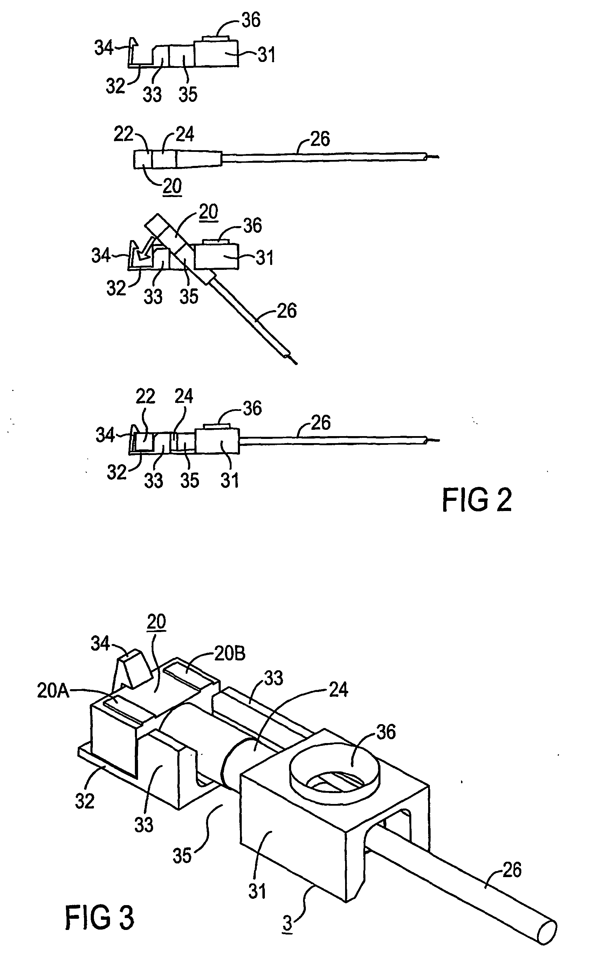

For mounting of the photoelectric transducer 20 into the transducer carrier 3 the photoelectric transducer 20 is introduced from below into the opening 35 of the bottom section 32 with the ceramic body containing the photodiode 22 first and the optical axis oriented orthogonal to the bottom section 32, as can be seen in FIG 2. Then, the photoelectric transducer 20 is rotated with the ceramic body and the photodiode 22 at its head towards the bottom section 32. The snapping element 34 is bent or deformed backwards and, subsequently, after the transducer 20 has passed it, snaps back by the elastic spring forces into a position resting, usually with a certain remaining spring pressure, on the ceramic body with the photodiode 22. At the same time, with this rotary movement, the optical glass fiber 26 is introduced from below into its passage in the rear area 31 of the transducer carrier 3.

The snapping element 34 also serves as a stop lug for stopping the ceramic body with the photodiode 22 and therefore the whole transducer 20 from moving to the front or upwardly. The front portions of the side sections 33 of the transducer carrier 3 serve as stops preventing a backward movement of the ceramic body with the photodiode 22 and thus the transducer 20. Together the snapping element 34 and the side section 33 form containment or holding sections for keeping the transducer 20 from falling out in any direction. The photoelectric transducer 20 is thus held firmly in the transducer carrier 3 and can be removed at any time by performing the steps shown in FIG 2 backwards.

FIG 3 shows the transducer unit resulting from the assembly according to FIG 2 with the transducer 3 mounted in the transducer carrier 3 in an isometric front view.

Returning to FIG 1, the carrier holder (or: frame cover) 5 is shaped as a rectangular frame, has a closed side wall 50 and a transducer platform 54 for the transducer carrier 3 at the bottom and next to the side wall 50 and is open, i.e. without a cover or roof, at the top. At the inner side of the transducer platform 54 at a distance from the side wall 50 a hook-shaped snapping element 53 is arranged extending upright from the bottom to the top of the carrier holder 5. At one end of the transducer platform 54 a crosspiece or bar 55 is extending in a perpendicular direction from the side wall 50. at the same long side of the side wall 50 as the transducer platform 54.

Axially disposed or parallel to this long side or the side wall 50 a cut-out section or opening (or: passage) 51 is formed in the shorter side of the side wall 50 orthogonal to the longer side. At the inner side behind this opening 51 a receiving portion 52 is formed within the carrier holder 5 by two vertical grooves and a bottom section for receiving the lower bearing part 72. Below the opening 51 a first adjusting aid 56 is formed protruding from the side wall 50 outwardly and vertically and a second adjusting aid 57 similar to the first one is formed at the same short side about in the middle.

At the two shorter sides of the side wall 50 two pins 5A and 5B (only 5B visible in FIG 1) are formed extending downwards parallel to the side wall 50 and jutting out from the rest of the carrier holder 5. These two pins 5A and 5B are formed in diameter and spaced apart in such a manner that they can be inserted simultaneously into the corresponding inner holes 15A and 15B in the substrate carrier body 17 in order to mount the carrier holder 5 onto the substrate carrier body 17 and, thus, onto amplifier 10.

The top cover 6 is shaped basically as a rectangular box to be arranged onto and/or around the carrier holder 5, thus forming a closed housing for protection of the transducer 3 wherein the top cover 6 forms the upper part and the carrier holder 5 the lower part of the housing. A longer side of the top cover 6 has a recessed edge 68 which is to be rested on a corresponding base 58 at the outside of the side wall 50 at the longer side of the carrier holder 5. For adjusting the relative position of the top cover 6 and the carrier holder 5 the top cover 6 has a longer opening 61 for receiving and guiding the first adjusting aid 56 of the carrier holder 5 and a shorter opening 67 for receiving and guiding the second adjusting aid 57. At the closed ceiling or top wall of the top cover 6 a receiving portion (not visible) similar to the receiving portion 52 in the carrier holder 5 is formed within the top cover 6 for receiving the upper bearing part 71.

At the shorter side walls of the top cover 6 two pins 6A and 6B and 6C and 6D are arranged respectively all extending downwardly and meant to be inserted into the outer connection holes 16A through 16D of the substrate carrier body 17 respectively for connecting the top cover 6 with or to the substrate carrier body 17.

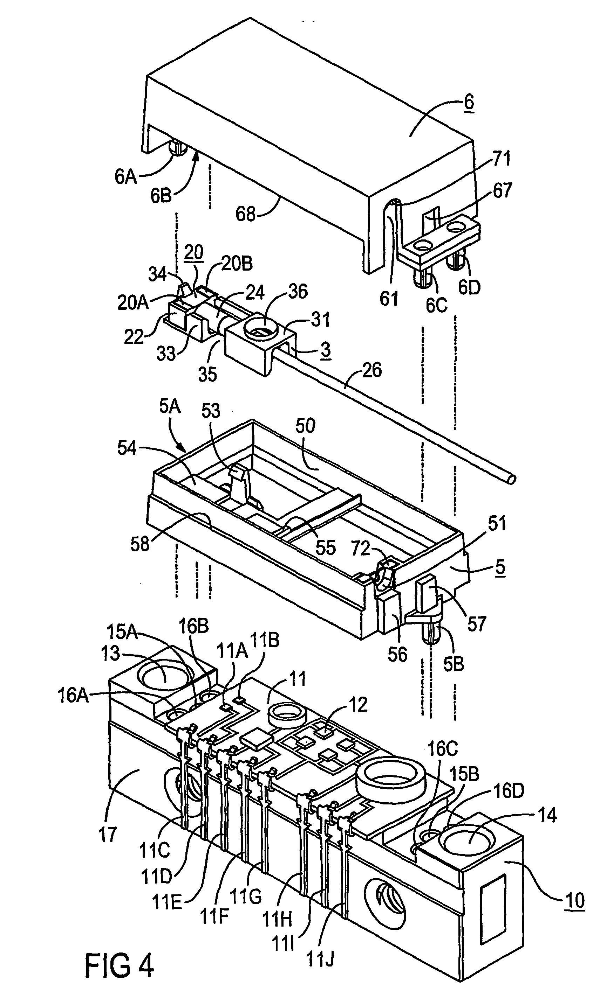

In FIG 4 the assembled transducer unit is shown in a rear view. Furthermore, in FIG 4 compared to the initial state shown in FIG 1, the lower bearing part 71 is already mounted into its corresponding receiving portion 51 in the carrier holder 5 and the other bearing part 72 is mounted into its corresponding receiving portion (not visible) in the top cover 6 behind the opening 61.

The photoelectric transducer 20 mounted in its transducer carrier 3 may now be removably mounted into or onto transducer platform 54 of the carrier holder 5 with the use of the snapping element 53 and the bar 55 serving as holding aids. To this purpose the snapping element 53 is bent backwards allowing the transducer carrier 3 to be snapped in and afterwards snaps back and rests on one of the side walls 33 with a certain remaining spring force. The transducer carrier 3 is thus fixed between the side wall 50 and the snapping element 54 laterally and between the side wall 50 and the bar 55 longitudinally or axially.

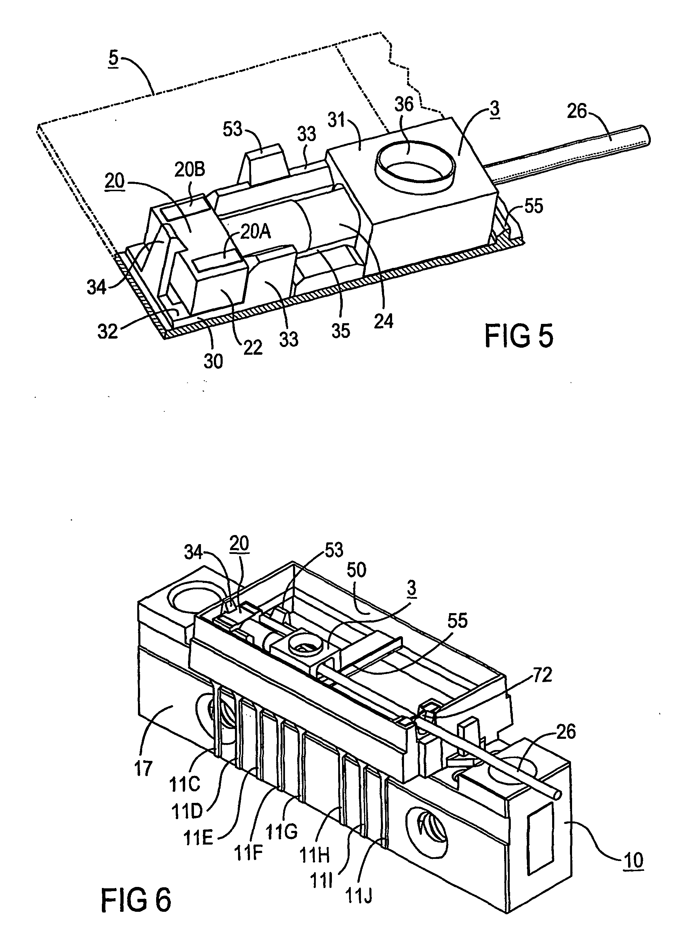

FIG 5 and 6 show the transducer carrier 3 held in such a manner in the carrier holder 5.

The holding aids (50, 53 and 55) of the transducer platform 54 and (33, 34) of the transducer carrier 3 allow the transducer 20 to be held and fixed with or without the use of a glue. If glue is not used, subsequent cure processes can be avoided, if a glue is used however, applied through glue hole 36, no additional tools are required for transducer alignment, i.e., to hold the transducer 20 in its position during the cure processes time interval.

Eventually, as shown in FIG 6, the carrier holder 5 with the mounted transducer carrier 3 is mounted onto the substrate carrier body 17 by inserting its pins 5A and 5B into the corresponding connection holes (or: blind holes) 15A and 15B and resting the carrier holder 5 with its rim portion on the upper surface of the substrate carrier body 17. The pins 5A and 5B have a diameter which is equal to or slightly smaller or bigger than the corresponding connection holes 15A and 15B so that the pins 5A and 5B just fit into the corresponding holes 15A and 15B and, thus, properly align the carrier holder 5 to the heat sink or substrate carrier body 17 and substrate 11.

Therefore, the carrier holder 5 may be easily taken or lifted off the substrate carrier body 17 if, for example, the amplifier 10 is defective and must be removed. The carrier holder 5 with the most valuable photoelectric transducer 20 is, in this case, pulled apart from the substrate carrier body 17 and may be reused in another good amplifier.

As shown in FIG 6, the photoelectric transducer 20 is now held at a distance determined by the carrier holder 5 above the substrate 12 and in particular above the electrical contacts 11A and 11B so that these contacts 11A and 11B can be easily connected to the contacts 20A and 20B of the photodiode 22. The glass fiber 26 of the photoelectric transducer 20 is held in the lower bearing part 72 and guided through the opening 51 in the carrier holder 5.

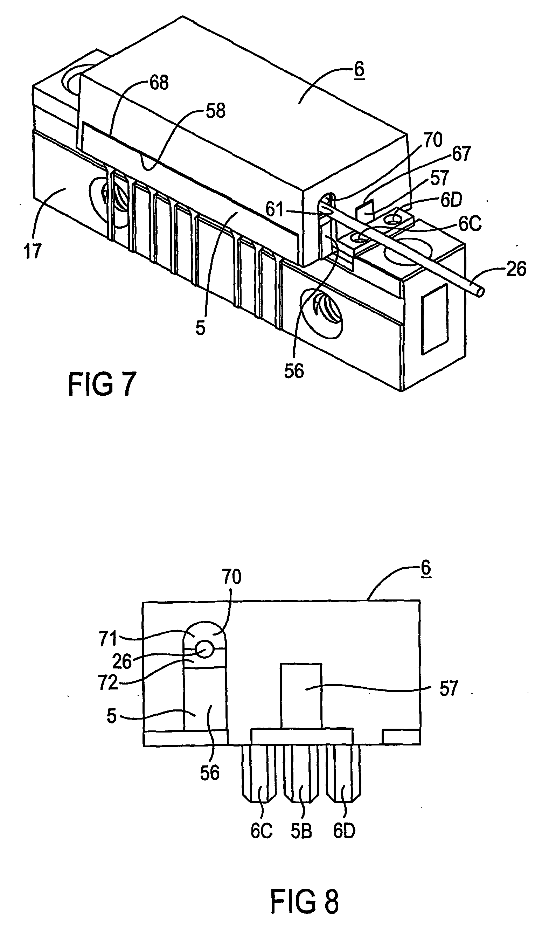

With reference to FIG 7 there is shown the completed mounting device assembly 100 with the top cover 6 mounted on top of the carrier holder 5 or frame cover. The carrier holder 5 incorporates the photoelectric transducer 20 assembled in the transducer carrier 3 (both not visible in FIG 7) which is snapped onto the transducer platform 54 (not visible in FIG 7) of the carrier holder 5, and the complete assembly is mounted to the substrate carrier body 17 and thus at the amplifier 10, in particular the amplifying circuits 12 on the substrate 11 in accordance with the present invention.

In FIG 8 this assembly according to FIG 7 is shown in a side view.

The mounted top cover 6 according to FIG 7 and FIG 8 provides mechanical protection for the amplifier 10 and the circuits 12 on the substrate 11.

The top cover 6 according to FIG 7 and 8 is mounted onto and partly over the carrier holder 5. Top cover 6 fixes the carrier holder 5 tightly to the substrate carrier body 17 and holds or pins it down by means of the four pins 16A through 16D, which, contrary to the two pins 5A and 5B of carrier holder 5, are pressed tightly or non-positively into their corresponding blind holes 16A through 16D in the substrate carrier body 17.

In another embodiment the pins 5A and 5B of the carrier holder 5 can also be larger in diameter and be pressed into the blind or connection holes 15A and 15B of the substrate carrier body 17 for the purpose to "fix" the carrier holder 5.

The pins 5A, 5B and 6A through 6D are preferably hollow in order to obtain a spring force or sufficient deformation, especially for a non-positive connection with the corresponding blind holes.

In order to loosen one of the non-positive pin-hole connections it is convenient to destroy the pins 5A and 5B and/or 6A to 6D by use of a drilling tool or the like and then withdraw the whole part, i.e. the carrier holder 5 or top cover 6.

Thus, the assembly of FIG 7 can be disassembled in the reverse order very easily by drilling open the pins 6A through 6D, removing the top cover 6 and arriving at the state shown in FIG 6 again and so forth.

The apparatus or device according to FIG 1 to 7 provides the capability to remove or re-cycle the transducer 20 easily from the amplifier 10 with minimum risk for the transducer 20 and/or the glass fiber 26 to be damaged during this process. This is particularly advantageous since the transducer 20 and the glass fiber 26 are typically significantly more expensive than the remainder of the amplifier 10 (by approximately a factor of two to three). Accordingly, if the amplifier portion 10 of the optical receiver module is discovered to be defective, the transducer 20 together with the frame cover or carrier holder 5 can be removed from the defective amplifier 10 and can be easily reused in another amplifier.

In the embodiment shown in FIG 7 and 8 the cut-out portions or "pockets" or openings 51 and 61 in the carrier holder 5 and the top cover 6 collectively form a closed opening or passage for the glass fiber 26, i.e. a fiber exit gate.

Within this opening or fiber exit gate the two elastic bearing parts 71 and 72 collectively form a soft or flexible ring-shaped or closed bearing 70 for the glass fiber 26. The two elastic bearing parts 71 and 72 can be shaped as complementing semi-rings together forming an opening for the glass fiber 26, as shown in FIG 8, or one of the two bearing parts, in particular the lower bearing part 72, can receive the optical fiber 26 and the other bearing part 71 supports or supplements the first bearing part 72. The length of the contacting area or surface between the bearing 70 and the glass fiber 26 measured along the optical axis of the glass fiber 26 is in particular smaller than the diameter of the glass fiber 26, preferably by a factor of at least 2.

The closed elastic ring of the bearing 70 guides the glass fiber 26 and is the center of rotation for the glass fiber if bend stress is applied to it from outside the top cover 6 while the bending continues inside the top cover 6. Thus the two halves or bearing parts 71 and 72 of the rubber bearing 70 at the fiber exit gate operate together so as to provide a flexible fixation of the fiber such that if the glass fiber is bent away, for instance from the substrate carrier body 17, a center of rotation effect at the fiber exit gate is provided.

This flexible bearing 70 provides maximum tolerance to glass fiber bend during assembly of the optoelectric hybrid device. In other words, the elasticity or softness of the bearing 70 is so high that the glass fiber 26 is rotating around within and in the proximity of the bearing 70 if any bend stress is applied onto the glass fiber 26 outside of the top cover 6. Thus, the fiber is not fixed tightly by the bearing 70 but aligned in a center of rotation only. Accordingly, every bend of the glass fiber 26 outside the cover 5 and 6 allows the fiber 26 to move inside the cover 5 and 6 in a way, that the bend radius is minimized in any case, thus providing a significant risk reduction to damage the glass fiber 26 e.g. during the assembly of the optical receiver module.

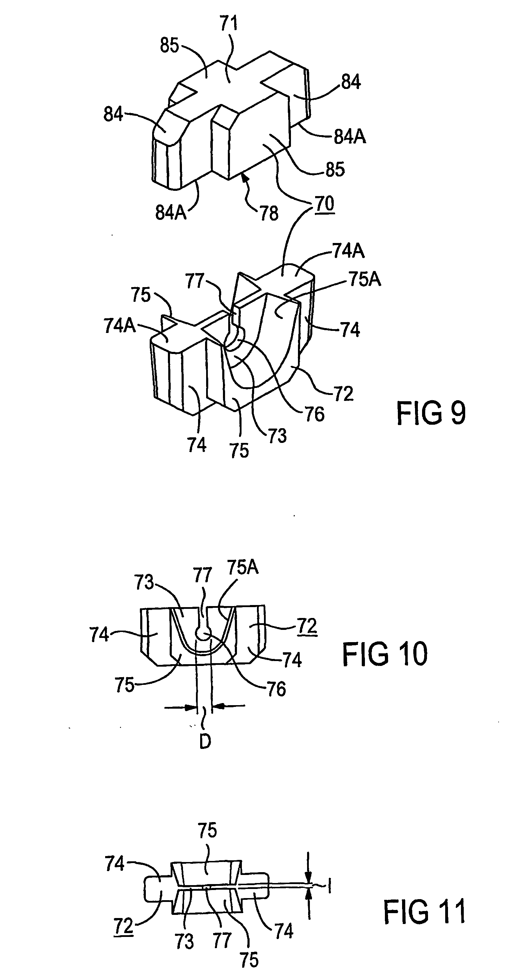

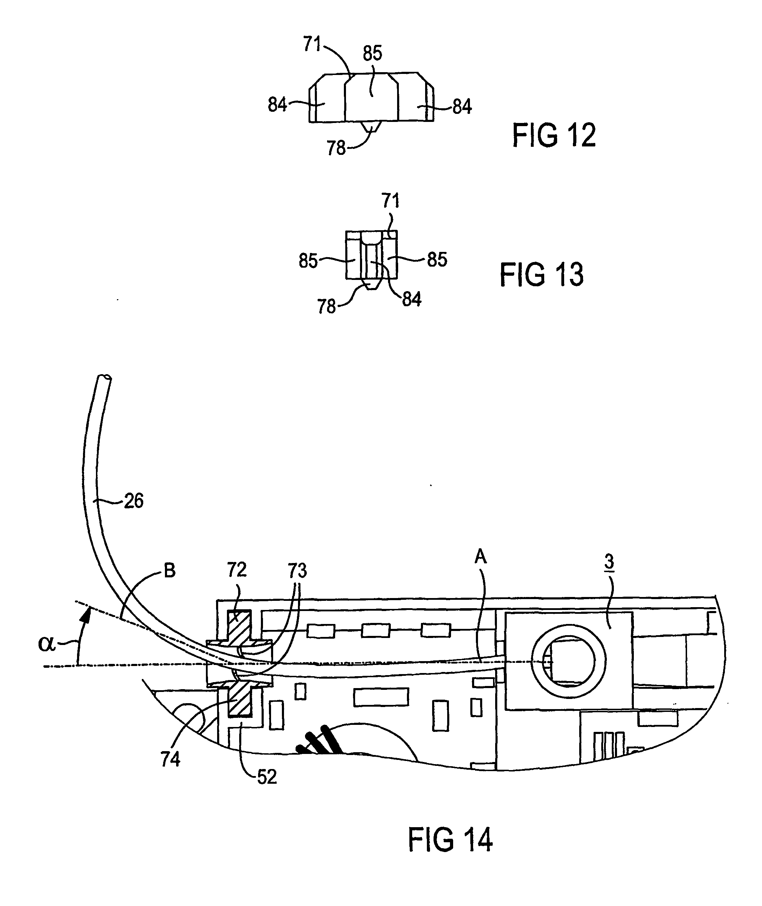

FIG 9 shows, in greater detail, the bearing 70 according to FIG 1, 4 and 6 for the glass fiber (light guide) 26 (not shown in FIG 9). FIG 10 and 11 show the lower bearing part 72 in two views and FIG 12 and 13 the upper part 71 in two views.

The bearing 70 consists of the lower bearing part 72 which receives a light guide (not shown in FIG 9 to 13) in an opening 76 and an upper bearing part 71 being mounted on to the lower bearing part 72.

The opening 76 is formed in a thin rubber lip, membrane or skin forming an inner bearing section 73. The opening 76 is arranged approximately in the center of the U- or V-shaped inner bearing part 73 and is accessible for the light guide through a guiding section 77 of smaller cross section than the opening 76 in order to keep the light guide within the opening 76. The glass fiber 26 is thus inserted into the opening 76 through the guiding section 77 and then held within the opening 76.

The diameter D of the opening 76 is of interfering dimensions and typically smaller than the diameter of the glass fiber 26, in particular by 5 % up to 30 %, in order to achieve a well-defined pre-stress and/or sealing property of the inner bearing section 73. A typical value for the diameter D is between 0.3 and 0.8 mm.

The thin inner bearing sections 73 is held at its boundary within a side section 74 of the lower bearing part 72. Extending longitudinally or axially with respect to the glass fiber 26 two front sections 75 on both sides of the inner bearing section 73 are formed each having a curved stop surface 75A for stopping the inserted light guide 26 when bent.

The upper bearing part 71 is formed as a massive piece having two side sections 84 and two front sections 85 corresponding to the side section 74 and the front sections 75 of the lower bearing part 72. The side sections 84 are, each with a lower flat surface 84A, placed onto a respective flat surface 74A of the side sections 74 of the lower bearing part 72. The front sections 85 close the open side section 75 so that a close, loop- or ring-shaped outer bearing section is formed.

The upper bearing part 71 is further equipped with a protruding part 78 which fits into the guiding section 77 of the inner bearing section 73 and closes the guiding section 77 in order to keep light guide within the opening 76 and to keep it, as a spacer, away from the front sections 85 and 75 and supports the three-dimensional movement of the fiber 26. The protruding part 78 together with the keyhole-shaped passage consisting of the opening 76 and the guiding section 77 also serves as an assembly jig and for self-centering of the glass fiber 26.

The opening angle of the V- or U-shaped front section 75 and therefore the stop surface 75A and the inner bearing section 73 is preferably chosen to be approximately 30°. The U-/V-shaped inner bearing section 73, also with the corresponding protruding part 78 of the upper bearing part 71, allows for approximately symmetrical forces on the light guide despite the non-symmetrical two bearing parts 71 and 72.

Ideally an elastic, preferably very soft, material may be chosen as material for the bearing 70 or at least its inner bearing section 73, in particular a rubber or other elastomer, thereby allowing for a low force to be applied to the glass fiber 26 by the two rubber halves or rubber guides of the bearing parts 71 and 72.

The elastic material for the bearing 70, at least for its inner bearing section 73, has preferably a Shore A value of typically between 20 and 90. As elastomer for instance a liquid silicon rubber (LSR), SI, SIS, NR or latex rubber, polymers based on ethylen and propylen polymers such as EPM, EPDM (ethylen-propylen-dien) rubber or a NBR rubber.

The whole lower bearing part 72 and also the upper bearing part 71 can be formed of an integral piece of elastomer, in particular by injection-moulding in one or two steps of a thermoplastic elastomer. The high elasticity of the inner bearing part 73 compared to the outer bearing section consisting of the side section 74 and front section 75 is, in this embodiment, mainly achieved by the different thickness or dimensions of the inner bearing sections 73 compared to the outer bearing section 74 and 75. Thus, the inner bearing section 73 will be deformed much easilier than the outer bearing section 74 and 75.

FIG 14 shows the bearing according to the invention in a transducer carrier 5 with a glass fiber 26 as a light guide being fixed within the passage of the rear section 31 of the transducer carrier 3. The glass fiber 26 is bent outside of the housing or transducer carrier 5. The axis of the glass fiber 26 in the normal position without bending is designated with A.

In the bent situation shown in FIG 14 the glass fiber 26 is arranged with its longitudinal or optical direction, designated by an optical axis B at an angle α to the original optical axis A and further curved away from this optical axis B within and beyond the bearing 70. The glass fiber 26 bent on one side therefore pivots in the bearing 70 from the position defined by the axis A to the position defined by axis B, comparable to a pivotable lever.

As can be clearly seen in FIG 14, the inner bearing part 73 is deformed to a great extent whereby the parts or two sides of the inner bearing section 73 on opposite sides of the glass fiber 26 are deformed in opposite directions. Thus, the glass fiber 26 is, between the fixing point in the rear part 31 of the carrier holder 3 and the bearing 70, curved with the same curvature sign (positive or negative) inside the housing or carrier holder 5 as outside of the housing 5 or on both sides of the bearing 70. Hence, by means of the deformation of the inner bearing part 73 of the bearing 70 the bent radius of the glass fiber 26 is increased and thus bending stress is reduced.

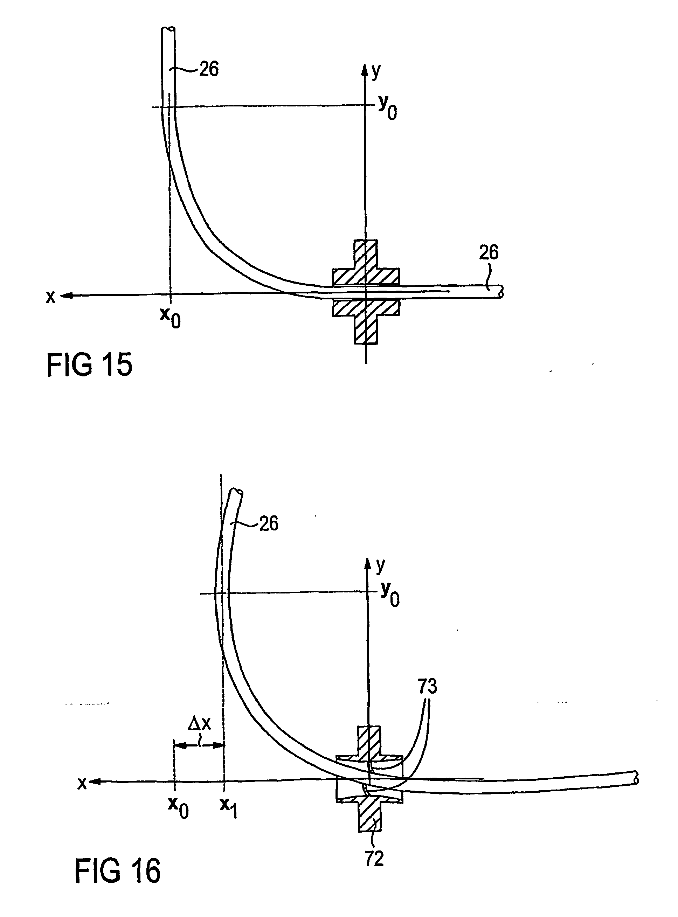

In FIG 15 and 16 a comparison between a bearing according to the prior art (FIG 15) and the bearing 70 according to the invention (FIG 16) is given.

In the prior art solution according to FIG 15 the glass fiber 26 is held fixedly and non-positively in the bearing by means of a rubber tube. The glass fiber 26 is displaced in a displacement direction designated y. The x-direction or coordinate is the corresponding distance of the glass fiber 26 from the bearing and is orthogonal to the y-axis and parallel to the longitudinal axis of the fiber 26 within the bearing. The fiber 26 is supposed to be bent at its maximal admissible curvature at a point with a distance x0 and a corresponding displacement y0 is shown.

In FIG 16 the same glass fiber 26 is held in the bearing 70 according to FIG 9 to 14 and displaced with the same displacement y0 as in FIG 15. As can be seen, since the glass fiber 26 is displaced also on the other side of the bearing, the distance x1 of the point (x1, y0) in FIG 16 with the same curvature as the point (x0, y0) in FIG 15 is smaller than x0. The difference Δ = x0 - x1 is the benefit of the flexible bearing 70. It means that the fiber 26 can be displaced closer to the bearing and, nevertheless, to the same extent y0 without inducing any damage as would happen in the prior art.

The glass fiber 26 can, in all embodiments, be a single mode or a multi mode fiber and formed of different suitable materials.

The transducer carrier 3, the carrier holder 5 and/or the top cover 6 in all embodiments can be formed by integral plastic parts, in particular injection-moulded parts, allowing for a cheap production and great flexibility in shape and function.

The design according to the invention, in particular in the embodiments shown in FIG 1 to 14, provides the capability to align the transducer 20 and the light guide 26 in the bearing 70 precisely with respect to the substrate 11 without the need for use of additional handling tools.

Many modifications of the embodiments shown in FIG 1 through 16 are possible within the scope of the invention. For instance, instead of or in addition to the photodiode 22 a different photo detector or a photoelectric transducer converting electrical signals into light or optical signals could be provided, for instance a laser or laser diode or LED, and could be arranged at the signal processing device in a similar manner as the photodiode 22. This embodiment could, for example, be used in a bi-directional CATV system.

### LIST OF REFERENCE SYMBOLS

- 3: transducer carrier
- 5: carrier holder
- 5A, 5B: pin
- 6: top cover
- 6A to D: pin
- 10: amplifier
- 11: substrate
- 11A,11B: contact
- 11C to K: contact
- 12: signal processing circuits
- 13, 14: screw hole
- 15A, 15B: connection hole
- 16A to D: connection hole
- 17: substrate carrier body
- 20: photoelectric transducer
- 21 22: photo diode
- 20A, 20B: contact
- 24: ferrule
- 26: glass fiber
- 30: front area
- 31: rear area
- 32: bottom section
- 33: side section
- 34: snapping element
- 35: opening
- 36: glue hole
- 37: edge
- 50: side wall
- 51: opening
- 53: snapping element
- 54: transducer platform
- 55: bar
- 56, 57: adjusting aid
- 58: base
- 61: opening
- 67: opening
- 70: bearing
- 71,72: bearing part
- 73: inner part
- 74: outer part
- 74A: surface
- 75: stop part
- 75A: surface
- 76: opening
- 77: guiding section
- 78: protruding part
- 84: outer part
- 84A: surface
- 85: stop part
- A: main axis
- B: axis
- x0,x1,Δx: distance
- y0: displacement

## Claims

1. Device for holding a light guide, in particular an optical fiber (26), preferably a glass fiber, comprising
a) at least one bearing (70) having
a1) a reversibly deformable inner bearing section (73) being provided with an opening (76) or passage for the light guide (26) and
a2) an outer bearing section (74, 85) which is less deformable than the inner bearing section (73),
b) wherein the inner bearing-section (73) and the outer bearing section (74, 85) are formed and arranged in such a manner that the light guide (26) can be moved within the bearing under deformation of the inner bearing section (73) such movement of the light guide (26) being limited by the outer bearing section (74, 85),
c) **characterized in that** the bearing is composed of two separate bearing parts (71, 72),
d) wherein a first (71) of these two bearing parts is removably mounted on the second (72) of the two bearing parts, wherein the two bearing parts, when mounted, collectively form the bearing, and wherein a first part section (85) of the outer bearing section is included in the first bearing part (71) and a second part section (74) of the outer bearing section is included in the second bearing part (72).

2. Device as claimed in claim 1, wherein the inner bearing section (73) and the outer bearing section (74, 85) are formed and arranged in such a manner that a bending or displacement of the light guide (26) at one side of the bearing results in a deformation of the inner bearing section (73) and in a bending or displacement of the light guide (26) on the other side of the bearing, preferably in the opposite direction.

3. Device as claimed in claim 1 or claim 2, wherein said bearing (70) provides a pivoting area for the light guide (26).

4. Device as claimed in claim 3, wherein the inner bearing section (73) and the outer bearing section (74, 85) are formed and arranged in such a manner that the light guide (26), when displaced outside of the bearing, pivots within the bearing (70) essentially in a pivoting plane containing the direction of the displacement.

5. Device as claimed in any of the preceding claims, wherein the inner bearing section (73) and the outer bearing section (74, 85) are formed and arranged in such a manner that in an off-set or zero position, i.e. when the light guide is not displaced or bent, the light guide (26) is held within the opening (76) or passage of the inner bearing section (73) under no or minimal deformation of the inner bearing section (73).

6. Device as claimed in claim 5, wherein the inner bearing section (73) and the outer bearing section (74, 85) are formed and arranged in such a manner that at least in the off-set or zero position and preferably in all positions the light guide (26) is held under prestress within the opening (76) or passage of the inner bearing section (73).

7. Device as claimed in claim 5 or claim 6, wherein the inner bearing section (73) and the outer bearing section (74, 85) are formed and arranged in such a manner that in the off-set or zero position the opening (76) or the light guide (26) is spaced apart from the outer bearing section (74, 85), in particular in a central region of the inner bearing section (73).

8. Device as claimed in one of the claims 5 to 7, wherein the inner bearing section (73) and the outer bearing section (74, 85) are formed and arranged in such a manner that in the off-set or zero position the light guide (26) extends longitudinally along a straight longitudinal axis (A) through the bearing and wherein preferably the inner bearing section (73) extends at least approximately transversally or orthogonal to this longitudinal axis.

9. Device as claimed in any of the preceding claims, wherein the length of the contacting area of the inner bearing section (73) for contacting the light guide (26), measured along the longitudinal extension of the light guide (26) within the inner bearing section (73), is smaller than a diameter of the opening (76) or passage in the inner bearing section (73) and/or smaller than a diameter of the light guide (26), in particular by a factor of at least 1.5, preferably at least 2.

10. Device as claimed in any of the preceding claims, wherein the width or outer diameter of the inner bearing section (73) in at least one direction orthogonal to the longitudinal extension of the light guide (26) within the inner bearing section (73) is larger than the diameter of the opening (76) or the light guide (26), in particular by a factor of at least 1.5, preferably at least 2.

11. Device as claimed in any of the preceding claims, wherein the outer bearing section (74, 85) is provided with at least one side section (84) for holding the inner bearing section (73) and at least one front section (85) being longitudinally displaced with respect to the inner bearing section (73) for limiting the movement of the light guide (26).

12. Device as claimed in any of the preceding claims, wherein the outer bearing section has a curved stop surface (75A) for the light guide (26).

13. Device as claimed in any of the preceding claims, wherein the whole inner bearing section (73) is included in the first bearing part (71).

14. Device as claimed in claim 13, wherein the opening (76) or passage in the inner bearing section (73) is connected to the peripheral region of the inner bearing section (73) by a guiding passage (77) for inserting the light guide (26) in said opening (76) or passage, the guiding passage (77) preferably having a smaller width or diameter than the opening (76) or passage.

15. Device as claimed in claim 14, wherein the first bearing part (71) is provided with a protruding part (78) insertable or inserted into the guiding passage (77) of the second bearing part (72).

16. Device as claimed in any of the preceding claims, wherein each of the bearing parts is held in a corresponding bearing holding part (52), wherein the bearing holding parts with their corresponding bearing parts are removable from each other.

17. Device as claimed in any of the preceding claims, wherein the inner bearing section (73) and the outer bearing section (74, 85) and/or each of the two bearing parts (71, 72) consist of an elastomer, in particular a thermoplastic elastomer, and/or are injection-moulded, in particular two-shot-injection-moulded.

18. Device as claimed in any of the preceding claims, wherein the inner bearing section (73) has a Shore A value between 20 and 90.

19. Device as claimed in any of the preceding claims, further comprising fixing means (3) for fixing the light guide (26) at least on one side of the bearing (70), the fixing means (3) being spaced apart from the bearing (70).

20. Device as claimed in any of the preceding claims, comprising several bearings for the light guide spaced apart from each other.

## Patentansprüche

1. Anordnung zum Haltern eines Lichdeiters, insbesondere einer optischen Faser (26), vorzugsweise einer Glasfaser, welche folgendes umfasst:
(a) mindestens eine Lagerung (70) mit
(a1) einem innen liegenden, umkehrbar verformbaren Lagerabschnitt (73), der mit einer Öffnung (76) bzw. einer Durchführung für den Lichtleiter (26) versehen ist, und mit
(a2) einem außen liegenden Lagerabschnitt (74, 85), der weniger stark verformbar als der innen liegende Lagerabschnitt (73) ist,
(b) bei welcher der innen liegende Lagerabschnitt (73) und der außen liegende Lagerabschnitt (74, 85) in der Weise geformt und angeordnet sind, dass der Lichtleiter (26) unter Verformung des innen liegenden Lagerabschnitts (73) innerhalb der Lagerung beweg bar ist, wobei eine derartige Bewegung des Lichtleiters (26) durch den außen liegenden Lagerabschnitt (74, 85) begrenzt ist,
**dadurch gekennzeichnet, dass**
(c) die Lagerung aus zwei getrennten Lagerteilen (71, 72) besteht, und bei welcher
(d) ein erstes (71) dieser beiden Lagerteile auf dem zweiten (72) der beiden Lagerteile lösbar angebracht ist, wobei die beiden Lagerteile im montierten Zustand zusammen die Lagerung bilden und wobei ein erster Teilabschnitt (71) und ein zweiter Teilabschnitt (74) des außen liegenden Lagerabschnitts in das zweite Lagerteil einbezogen ist.

2. Anordnung nach Anspruch 1, bei welcher der innen liegende Lagerabschnitt (73) und der außen liegende Lagerabschnitt (74, 85) in der Weise geformt und angeordnet sind, dass ein Verbiegen bzw. eine Verlagerung des Lichtleiter (26) auf einer Seite der Lagerung zu einer Verformung des innen liegenden Lagerabschnitts (73) sowie zum Verbiegen bzw. zu einer Verlagerung des Lichtleiters (26) auf der anderen Seite der Lagerung, vorzugsweise in der entgegen gesetzten Richtung, führt.

3. Anordnung nach Anspruch 1 oder Anspruch 2, bei welcher die Lagerung (70) für eine Schwenkfläche für den Lichtleiter (26) sorgt.

4. Anordnung nach Anspruch 3, bei welcher der innen liegende Lagerabschnitt (73) und der außen liegende Lagerabschnitt (74, 85) in der Weise geformt und angeordnet sind, dass der Lichtleiter (26) bei Verlagerung außerhalb der Lagerung im Inneren der Lagerung (70) im Wesentlichen in einer Schwenkebene verschwenkt, welche die Richtung der Verlagerung enthält.

5. Anordnung nach einem der vorhergehenden Ansprüche, bei welcher der innen liegende Lagerabschnitt (73) und der außen liegende Lagerabschnitt (74, 85) in der Weise geformt und angeordnet sind, dass bei einem Versatz bzw. einer Nullstellung, d.h. dann, wenn der Lichtleiter nicht verlagert oder geboten ist, der Lichtleiter (26) innerhalb der Öffnung (76) bzw. de4r Durchführung des innen liegenden Lagerabschnitts (73) ohne jede oder nur mit minimaler Verformung des innen liegenden Lagerabschnitts (73) gehalten ist.

6. Anordnung nach Anspruch 5, bei welcher der innen liegende Lagerabschnitt (73) und der außen liegende Lagerabschnitt (74, 85) in der Weise geformt und angeordnet sind, dass der Lichtleiter (26) zumindest in der Versatzposition bzw. der Nullstellung und vorzugsweise in allen Positionen innerhalb der Öffnung (76) bzw. der Durchführung des innen liegenden Lagerabschnitts (73) unter Vorspannung gehalten ist.

7. Anordnung nach Anspruch 5 oder Anspruch 6, bei welcher der innen liegende Lagerabschnitt (73) und der außen liegende Lagerabschnitt (74, 85) in der Weise geformt und angeordnet sind, das in der Versatzposition bzw. Nullstellung die Öffnung (76) bzw. der Wellenleiter (26) vom außen liegenden Lagerabschnitt (74, 85) beabstandet ist, insbesondere in einem Mittelbereich des innen liegenden Lagerabschnitts (73).

8. Anordnung nach einem der Ansprüche 5 bis 7, bei welcher der innen liegende Lagerabschnitt (73) und der außen liegende Lagerabschnitt (74, 85) in der Weise geformt und angeordnet sind, dass sich der Lichtleiter (26) in der Versatzposition bzw. der Nullstellung in Längsrichtung entlang einer geraden Längsachse (A) durch die Lagerung erstreckt, und bei welcher sich der innen liegende Lagerabschnitt (73) vorzugsweise zumindest in etwa quer bzw. senkrecht zu dieser Längsachse erstreckt.

9. Anordnung nach einem der vorhergehenden Ansprüche, bei welcher, gemessen entlang der Längserstreckung des Lichtleiters (26) im Inneren des innen liegenden Lagerabschnitts (73), die Länge der Berührungsfläche des innen liegenden Lagerabschnitts (73) zum Kontaktieren des Lichtleiters (26) kleiner ist als der Durchmesser der Öffnung (76) bzw. der Durchführung in dem innen liegenden Lagerabschnitt (73) und/oder kleiner als ein Durchmesser des Lichtleiters (26), insbesondere um einen Faktor von mindestens 1,5, vorzugsweise mindestens 2.

10. Anordnung nach einem der vorhergehenden Ansprüche, bei welcher die Breite oder der Außendurchmesser des innen liegenden Lagerabschnitts (73) in mindestens einer Richtung senkrecht zur Längserstreckung des Lichtleiters (26) innerhalb des innen liegenden Lagerabschnitts (73) größer ist als der Durchmesser der Öffnung (76) oder des Lichtleiters (26), insbesondere um einen von Faktor von mindestens 1,5, vorzugsweise mindestens 2.

11. Anordnung nach einem der vorhergehenden Ansprüche, bei welcher der außen liegende Lagerabschnitt (74, 85) mit mindestens einem Seitenabschnitt (84) zum Haltern des innen liegenden Lagerabschnitts (73) und mindestens einem vorderen Abschnitt (85) versehen ist, welcher zum Begrenzen der Bewegung des Wellenleiters (26) bezüglich des innen liegenden Lagerabschnitts (73) in Längsrichtung verschoben wird.

12. Anordnung nach einem der vorhergehenden Ansprüche, bei welcher der außen liegende Lagerabschnitt (73) eine gekrümmte Anschlagfläche (75A) für den Lichtleiter (26) aufweist.

13. Anordnung nach einem der vorhergehenden Ansprüche, bei welcher der gesamte innen liegende Lagerabschnitt (73) in das erste Lagerteil (71) einbezogen ist.

14. Anordnung nach Anspruch 13, bei welcher die Öffnung (76) bzw. die Durchführung in dem innen liegenden Lagerabschnitt (73) mit dem Umfangsbereich des innen liegenden Lagerabschnitts (73) mittels eines Führungskanals (77) zum Einführen des Lichtleiters (26) in die Öffnung (76) bzw. die Durchführung verbunden ist, wobei der Führungskanal (77) vorzugsweise eine kleine Breite bzw. einen kleineren Durchmesser als die Öffnung (76) bzw. Durchführung besitzt.

15. Anordnung nach Anspruch 14, bei welcher das erste Lagerteil (71) mit einem vorstehenden Teil (78) versehen ist, das in den Führungskanal (77) des zweiten Lagerteils (72) einführbar bzw. eingeführt ist.

16. Anordnung nach einem der vorhergehenden Ansprüche, bei welcher jedes der Lagerteile in einem entsprechenden Teil (72) zum Halten der Lagerung gehalten ist, wobei die Teile zum Halten der Lagerung mit deren entsprechenden Lagerteilen von einander entfernbar sind.

17. Anordnung nach einem der vorhergehenden Ansprüche, bei welcher der innen liegende Lagerabschnitt (73) und der außen liegende Lagerabschnitt (74, 85) und/oder jedes der beiden Lagerteile (71, 72) aus einem Elastomermaterial besteht, insbesondere einem thermoplastischen Elastomermaterial, und/oder spritzgegossen, insbesondere zweistufig spritzgegossen, ist.

18. Anordnung nach einem der vorhergehenden Ansprüche, bei welcher der innen liegende Lagerabschnitt (73) eine Shore-Härte A mit einem Wert zwischen 20 und 90 besitzt.

19. Anordnung nach einem der vorhergehenden Ansprüche, welche des Weiteren Befestigungsmittel (3) zum Befestigen des Lichtleiters (26) zumindest auf einer Seite der Lagerung (70) aufweist, wobei die Befestigungsmittel (3) von der Lagerung (70) beabstandet ist.

20. Anordnung nach einem der vorhergehenden Ansprüche, welche mehrere Lagerungen für den Lichtleiter aufweist, die von einander beabstandet sind.

## Revendications

1. Dispositif de support d'un guide de lumière, en particulier d'une fibre optique (26), dé préférence d'une fibre de verre, comprenant
a) au moins un palier (70) comportant
a1) une section de palier interne déformable d'une manière réversible (73) étant pourvue d'une ouverture (76) ou d'un passage pour le guide de lumière (26) et
a2) une section de palier externe (74, 85) qui est moins déformable que la section de palier interne (73),
b) où la section de palier interne (73) et la section de palier externe (74, 85) sont formées et agencées de telle manière que le guide de lumière (26) peut être déplacé dans le palier sous déformation de la section de palier interne (73) de sorte que le mouvement du guide de lumière (26) est limité par la section de palier externe (74, 85),
c) **caractérisé en ce que** le palier est constitué de deux parties de palier séparées (71, 72),
d) où une première (71) de ces deux parties de palier est montée amoviblement sur la seconde (72) des deux parties de palier, où les deux parties de palier, lorsqu'elles sont installées, forment collectivement le palier, et où une première section de partie (85) de la section de palier externe est incluse dans la première partie de palier (71), et une seconde section de partie (74) de la section de palier externe est incluse dans la seconde partie de palier (72).

2. Dispositif selon la revendication 1, où la section de palier interne (73) et la section de palier externe (74, 85) sont formées et agencées de telle manière qu'une courbure ou déplacement du guide de lumière (26) à un côté du palier se traduit par une déformation de la section de palier interne (73) et par une courbure ou déplacement du guide de lumière (26) sur l'autre côté du palier, de préférence dans la direction opposée.

3. Dispositif selon la revendication 1 ou 2, où ledit palier (70) réalise une zone de pivotement pour le guide de lumière (26).

4. Dispositif selon la revendication 3, où la section de palier interne (73) et la section de palier externe (74, 85) sont formées et agencées de telle manière que le guide de lumière (26), lorsqu'il est déplacé à l'extérieur du palier, pivote dans le palier (70) essentiellement dans un plan de pivotement contenant la direction de déplacement.

5. Dispositif selon l'une des revendications précédentes, où la section de palier interne (73) et la section de palier externe (74, 85) sont formées et agencées de telle manière que dans une position décalée ou zéro, c'est-à-dire lorsque le guide de lumière n'est pas déplacé ni courbé, le guide de lumière (26) soit retenu dans l'ouverture (76) ou dans le passage de la section de palier interne (73) sous aucune déformation ou déformation minimale de la section de palier interne (73).

6. Dispositif selon la revendication 5, où la section de palier interne (73) et la section de palier externe (74, 85) sont formées et agencées de telle manière qu'au moins dans la position décalée ou zéro et de préférence dans toutes les positions, le guide de lumière (26) est retenu sous précontrainte dans l'ouverture (76) ou le passage de la section de palier interne (73).

7. Dispositif selon la revendication 5 ou la revendication 6, où la section de palier interne (73) et la section de palier externe (74, 85) sont formées et agencées de telle manière que dans la position décalée ou zéro, l'ouverture (76) ou le guide de lumière (26) est espacé de la section de palier externe (74, 85), en particulier dans une région centrale de la section de palier interne (73).

8. Dispositif selon l'une des revendications 5 à 7, où la section de palier interne (73) et la section de palier externe (74, 85) sont formées et agencées de telle manière que dans la position décalée ou zéro, le guide de lumière (26) s'étend longitudinalement le long d'un axe longitudinal droit (A) à travers le palier et où de préférence la section de palier interne (73) s'étend au moins approximativement transversalement ou orthogonalement à cet axe longitudinal.

9. Dispositif selon l'une des revendications précédentes, où la longueur de la zone de contact de la section de palier interne (73) pour venir en contact avec le guide de lumière (26) mesurée le long de l'extension longitudinale du guide de lumière (26) dans la section de palier interne (73) est plus petite qu'un diamètre de l'ouverture (76) ou du passage dans la section de palier interne (73) et/ou plus petite qu'un diamètre du guide de lumière (26), en particulier selon un facteur d'au moins 1,5, de préférence d'au moins 2.

10. Dispositif selon l'une des revendications précédentes, où la largeur ou le diamètre externe de la section de palier interne (73) dans au moins une direction orthogonale à l'extension longitudinale du guide de lumière (26) dans la section de palier interne (73) est plus grande que le diamètre de l'ouverture (76) ou du guide de lumière (26), en particulier selon un facteur d'au moins 1,5, de préférence d'au moins 2.

11. Dispositif selon l'une des revendications précédentes, où la section de palier externe (74, 85) présente au moins une section latérale (84) pour retenir la section de palier interne (73) et au moins une section frontale (85) étant déplacée longitudinalement par rapport à la section de palier interne (73) pour limiter le mouvement du guide de lumière (26).

12. Dispositif selon l'une des revendications précédentes, où la section de palier externe présente une surface d'arrêt courbée (75A) pour le guide de lumière (26).

13. Dispositif selon l'une des revendications précédentes, où toute la section de palier interne (73) est incluse dans la première partie de palier (71).

14. Dispositif selon la revendication 13, où l'ouverture (73) ou le passage dans la section de palier interne (73) est reliée à la région périphérique de la section de palier interne (73) par un passage de guidage (77) pour insérer le guide de lumière (26) dans ladite ouverture (76) ou ledit passage, le passage de guidage (77) ayant de préférence une largeur ou diamètre plus petit que l'ouverture (76) ou le passage.

15. Dispositif selon la revendication 14, où la première partie de palier (71) présente une partie saillante (78) insérable ou insérée dans le passage de guidage (77) de la seconde partie de palier (72).

16. Dispositif selon l'une des revendications précédentes, où chacune des parties de palier est retenue dans une partie de retenue de palier correspondante (52), où les parties de retenue de palier avec leurs parties de palier correspondantes sont détachables les unes des autres.

17. Dispositif selon l'une des revendications précédentes, où la section de palier interne (73) et la section de palier externe (74, 85) et/ou chacune des deux parties de palier (71, 72) sont constituées d'un élastomère, en particulier d'un élastomère thermoplastique et/ou sont moulées par injection, en particulier moulées par injection en deux charges.

18. Dispositif selon l'une des revendications précédentes, où la section de palier interne (73) présente une valeur Shore A entre 20 et 90.

19. Dispositif selon l'une des revendications précédentes, comprenant en outre des moyens de fixation (3) pour fixer le guide de lumière (26) au moins sur un côté du palier (70), les moyens de fixation (3) étant espacés du palier (70).

20. Dispositif selon l'une des revendications précédentes, comprenant plusieurs paliers pour le guide de lumière espacés les uns des autres.
